# EUROPEAN PATENT APPLICATION

(11) **EP 4 657 521 A1**
(43) Date of publication of application: **03.12.2025**
(21) Application number: 24178921.3
(22) Date of filing: 29.05.2024
(51) Int. Cl.: H01L 23/495, H01L 21/56, H01L 23/31

(54) **A METHOD OF FABRICATING A SEMICONDUCTOR INTEGRATED CIRCUITS PACKAGE**

(71) Applicant: Nexperia B.V., 6534 AB Nijmegen (NL)
(72) Inventor: Li, Zhiwen, Guangdong (CN); Yeung, Shun Tik, Hong Kong (HK); Ramalingam, Vegneswary, 71450 Seremban (MY)
(74) Representative: Pjanovic, Ilija

(57) **Abstract**

The present disclosure discloses a method of fabricating a semiconductor integrated circuits package with solder wettable plating, comprising the following steps: providing an array of leadless packages placed on singulation tape, wherein the array comprises a lead frame, each having contact pads at the underside and an encapsulation layer in which the integrated circuits are encapsulated; adjoining a conductive substrate to the array of leadless packages at the bottom side, thereby electrically connecting all contact pads of the array; performing a first set of parallel cuts, extending fully through the lead frame and encapsulation layer, and defining rows of the array, thereby exposing the side walls of the lead frames; performing the process of electro-plating of the lead frame, thereby obtaining plating on the areas not covered by the conductive substrate; removing the conductive substrate from the bottom of the packages; performing a second series of parallel cuts, angled with respect to the first series of parallel cuts, the cuts extending fully through the lead frame and the encapsulation layer, and separating the array into columns thereby singulating the packages between the edge portions. The step of performing a second series of parallel cuts is performed after removing the conductive substrate (for DFN packages) or after the step of performing the first set of parallel cuts and before plating step (for QFN packages).

## Description

### TECHNICAL FIELD

The present disclosure relates to a semiconductor package substrate with side wettable flank (SWF) features and a method of manufacturing thereof. In particular, this disclosure relates to leadless semiconductor devices and an associated method of manufacturing such devices.

### BACKGROUND OF THE DISCLOSURE

Nowadays, as packaging density has significantly increased, semiconductors are transitioning towards technologies that favour leadless packaging. Leadless packages save space by keeping the contact points underneath the component instead of on their perimeter. This extra space is crucial for applications like mobile devices, tablets, and wearables. Thus, modern devices involve mostly leadless packaging, such as dual/quad flats with no leads (DFN/QFN).

Typical semiconductor devices comprise a semiconductor die attached to a lead metallic frame and encapsulated forming a semiconductor package. Bonding pads on the die are electrically connected to leads of the lead frame with bond wires. This assembly is encapsulated with a mould compound, which protects the die and wire bonds from environmental and physical damage. The resulting IC package can then be mounted onto a printed circuit board (PCB) and/or connected to other electrical components. The leads are non-wettable at their flanks due to the untreated copper surface that is exposed yet flush with the side walls of the device. That is, due to the manner in which the semiconductor packages are singulated with a saw blade, the surface of the exposed lead or flank is flush with the mould compound of the device such that solder does not readily climb-up or "wick" the flank of the package meaning that the QFN package is not flank wettable during reflow. This makes it difficult to perform optical inspection of the solder joints after the package has been attached to a substrate or circuit board. Furthermore, this also reduces the solderable area of the leads thus reducing solder strength.

Therefore, wettable flank features by step cut or dimple is recommended to be adopted at the terminals side wall for tin plating and to allow a good solder fillet joint to be created at those locations. Wettable flank options can provide a protective coating to surface mount device lead surfaces to mitigate corrosion and lengthen shelf-life of an electronic device prior to soldering onto a host printed circuit board (PCB). Wettable flanks also facilitate automated optical inspection (AOI) of devices soldered to a PCB for determining whether a proper connection has been made on a pad under the device.

Side wettable flank (SWF) feature for leadless packages is required from automotive customer. After mounting on PCB, solder fillet will form that poor solder joint can be detected visually. However, a solder fillet joint is only formed at the terminals side walls, which are exterior of the package, and no solder fillets are formed at the terminals side walls interior of the package. When multiple flat no-lead packages are manufactured together and then singulated, it may be difficult to obtain good solder connections to lead lands located on side flanks of an IC package, because these side portions are not coated with solder wettable material prior to singulation. Further, it may be difficult to inspect solder connections to the lead lands by visual inspection.

Accordingly, an object of the present disclosure is to provide a manufacturing technique allowing full plating of the side flanks by conventional electro-plating with an external conductive media.

### SUMMARY OF THE DISCLOSURE

The present disclosure discloses a method of fabricating a semiconductor integrated circuits package with solder wettable plating, comprising the following steps:
(a) providing an array of leadless packages placed on singulation tape, wherein the array comprises a lead frame, each having contact pads at the underside and an encapsulation layer in which the integrated circuits are encapsulated;
(b) adjoining a conductive substrate to the array of leadless packages at the I/O side, thereby electrically connecting all contact pads of the array;
(c) performing a first set of parallel cuts, extending fully through the lead frame and encapsulation layer, and defining rows of the array, thereby exposing the side walls of the lead frames;
(d) performing the process of electro-plating of the lead frame, thereby obtaining plating on the areas not covered by the conductive substrate;
(e) removing the conductive substrate from the bottom of the packages;
(f) performing a second series of parallel cuts, angled with respect to the first series of parallel cuts, the cuts extending fully through the lead frame and the encapsulation layer, and separating the array into columns thereby singulating the packages between the edge portions,
whereby step (f) is performed after step (e) or between steps (c) and (d).

The step order a - b - c - d - e - f is applicable to dual flat no-lead (DFN) packages. In case of quad flat no-lead (QFN) packages, the second cut is performed before plating, and thus the step order is a - b - c - f - d - e.

Preferably, the conductive substrate is a conductive tape.

Preferably, the conductive tape fully covers the bottom side of each package.

Alternatively, the conductive tape partially covers the bottom side of each package. This allows to obtain selective plating of the I/O (bottom) side.

Alternatively, the conductive substrate is a conductive glue.

Preferably, the conductive glue fully covers the bottom side of each package.

Alternatively, the conductive glue partially covers the bottom side of each package. This allows to obtain selective plating of the I/O (bottom) side.

Preferably, the plating is tin plating.

Preferably, each package comprises six contact pads.

Preferably, the conductive substrate is UV-releasable and is removed using UV.

Alternatively, wherein the conductive substrate is heat-releasable and is removed using heat.

### BRIEF DESCRIPTION OF THE DRAWINGS

The disclosure will now be discussed with reference to the drawings, in which:
Fig. 1 shows a known method of singulation of an array of encapsulated integrated circuits into individual integrated circuit packages;
Fig. 2 shows method steps (partial Fig. 2A-2E) for fabricating a semiconductor integrated circuits package according to the first embodiment;
Fig. 3 shows the package obtained according to the first embodiment in the top view and in the side view;
Fig. 4 shows method steps (partial Fig. 4A-4E) for fabricating a semiconductor integrated circuits package according to the second embodiment;
Fig. 5 shows the package obtained according to the second embodiment in the top view and in the side view;
Fig. 6 shows method steps (partial Fig. 6A-6E) for fabricating a semiconductor integrated circuits package according to the third embodiment;
Fig. 7 shows the package obtained according to the third embodiment in the top view and in the side view.

### DETAILED DESCRIPTION OF THE DISCLOSURE

For a proper understanding of the disclosure, in the detailed description below corresponding elements or parts of the disclosure will be denoted with identical reference numerals in the drawings.

Currently, in the state of the art, the four sides solderable leadend is realized by step cut method, followed by plating process. In such a process the flanks are not being fully plated, and the application is limited on thick lead frame and large pitch.

The method according to the present disclosure allows to realize four side full feature solder wettable flanks by conventional electro-plating method with an external conductive media.

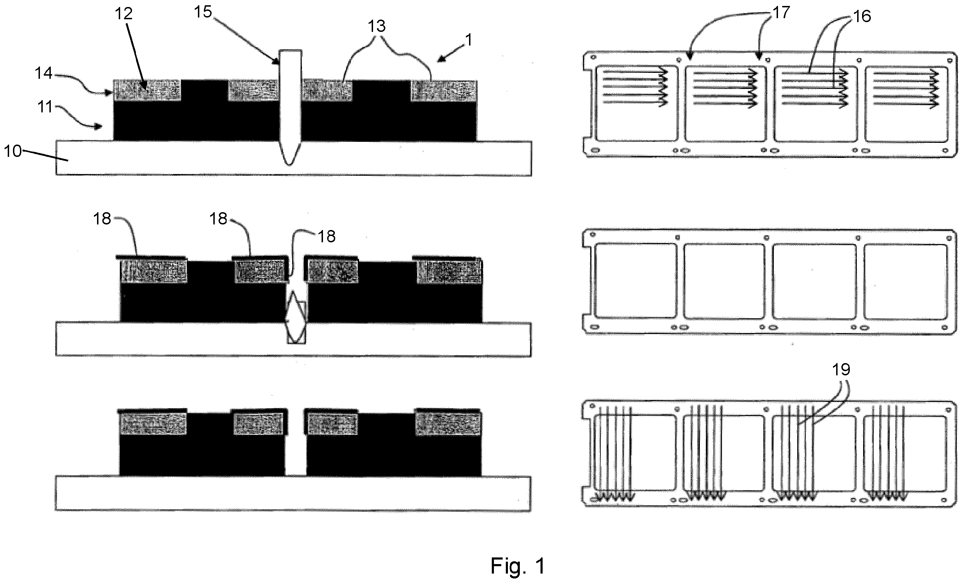

The present disclosure uses a known singulation method for an array of leadless packages. This known method of singulation will be described with reference to Fig. 1.

In Fig. 1, four complete package structures 1 are shown over the singulating tape 10, holding the packages 1 in place. Each package 1 structure has an array of integrated circuits embedded in an encapsulation layer 11. These circuits connect to a lead frame 12 in conventional manner.

The first step of the known singulation process is to provide a first set of full depth cuts 16, using a sawing blade 15, to expose side walls 11 of the lead frame 12 contact pad 13. This is shown in the top part of Fig. 1. The first set of full depth cuts 16 extends through the lead frame 12 and the encapsulation layer 11, but it does not extend fully across the package structures 1. Instead, the cuts terminate before the beginning and end of the rows such that the integrity of the array is maintained by edge portions 17 at the ends of the rows. These edge portions 17 can comprise the first and last device areas in the row.

After the first set of cuts 16, by maintaining the structural integrity, the structure is suitable for handling by an automatic feeder for the plating process. The base areas of the contact pads 13 as well as the side walls 11 are thus provided with plating 18, for example tin plating. The opposite end portions of the rows, in the known solution, are not used to form devices, and can simply comprise additional dummy areas.

After plating, to fully singulate the packages 1, only one further set of full depth cuts is needed. This second set of cuts 19 is orthogonal to the first set of cuts 16 and divides the structure 10 into a grid.

The known process can be used for multiple I/O terminal configurations. The terminals need to be electrically connected to each other after the first cut, so that they together define a plating electrode. In the case of 2 I/O terminals, one on each side of the package, tie bars connect all terminals together even after the first cut, and the terminals are only isolated from each other after the second cut. For example, assuming the first cut divides the array into rows, the terminals along the rows are connected by tie bars, and the terminals of the different rows are connected together at the row ends, where the first cut has not been made. This approach can be used when there are two terminals on one side and one terminal on the other side-again all three terminals can be connected together by column-direction tie bars.

The reference to rows and columns is arbitrary, and these terms should simply be understood as used to denote angled (ideally near orthogonal) lines, so that they together define a grid. Thus, "row" and "column" do not have any special meaning in relation to the package contents or connection terminals.

The process according to the present disclosure allows to obtain a leadless package with 4 sides solderable leadend - in effect, the solderable metal in lead sidewalls are fully plated. The surface finish of lead sidewall and bottom surface can be identical or different to fit the design requirements.

In general, the process according to the disclosure involves attaching a conductive substrate 20 (e.g. conductive tape 20a or conductive glue 20b) to the (partially) singulated packages to provide conductive path for the isolated I/O pins in molded package during electro-plating. The conductive substrate is removed after plating. This method is applicable to all leadless packages, including both 2-side leadless DFN and 4-side leadless QFN package. The resulting package, depending on the placement of the conductive substrate 20, may be fully or partially plated on the I/O (bottom) side of it.

The present disclosure will be explained in detail in three embodiments. The same reference numerals are used to denote the same components as in Fig. 1 referring to the state of the art..

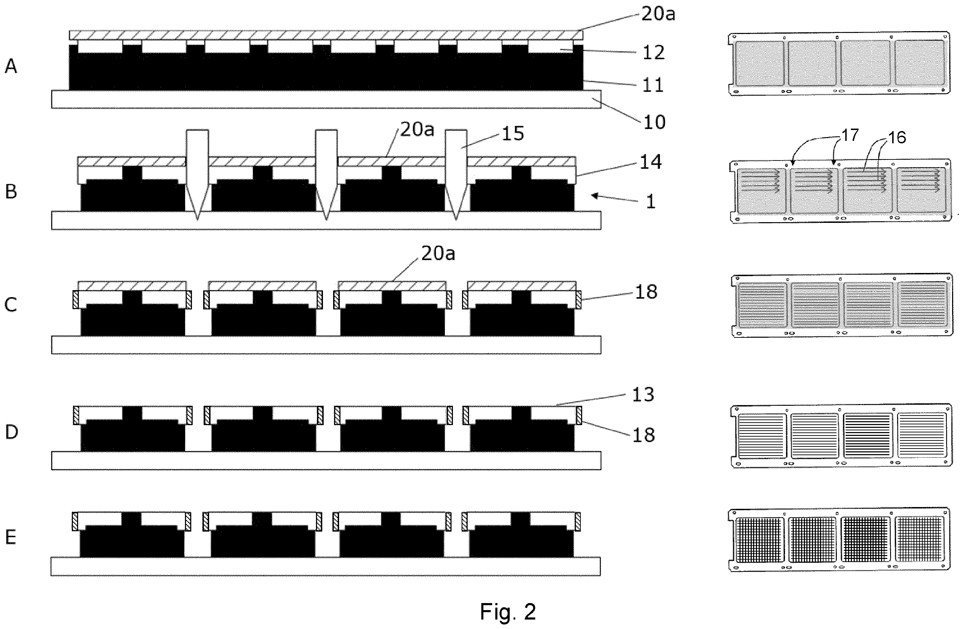

Figure 2 (partial Fig. 2A-2E) depicts a method according to the first embodiment, wherein the array of leadless packages 1 placed on singulation tape 10 is shown in the cross-section, i.e. in the end view (left side of Fig. 2), and from above, i.e. from the lead frame level (right side of Fig. 2). In the first embodiment, the conductive substrate is a conductive tape 20a. The conductive tape 20a may be for example a PVC-based conductive tape. The lead frame is preferably pre-plated with wettable metal, for example NiPdAu. Providing packages with tin plating only on the sides allows eliminate lead frame pre-plating cost.

In the first step (Fig. 2A), an array of leadless packages 1 placed on singulation tape 10 is provided, wherein the array comprises a lead frame 12, each having contact pads 13 at the underside and an encapsulation layer 11 in which the integrated circuits are encapsulated.

In the second step (Fig. 2B), the conductive tape 20a, for example adhesive conductive UV tape, is applied to the array of leadless packages 1 at the I/O (bottom) side, to provide conductive path for the isolated I/O pins in molded package during electro-plating. The conductive tape 20a fully covers the bottom side of each package 1.

In the third step (Fig. 2C), the first set of cuts 16 is performed to expose side walls 14 of the lead frame contact pad 13. The first set of cuts 16 extends through the lead frame 12 and the encapsulation layer 11, but it does not extend fully across the package 1 structures. Instead, the cuts terminate before the beginning and end of the rows such that the integrity of the array is maintained by edge portions at the ends of the rows. In effect, due to the presence of the conductive tape, all contact pads 13 are electrically connected.

In the fourth step (Fig. 2D), the structure is suitable for handling by an automatic feeder for the plating process (traditional, known electro-plating, e.g. immersion tin plating). The base areas of the contact pads 13 as well as the side walls 14 are thus provided with plating 18, for example tin plating. The conductive tape 20a acted as an electrical connecting media to enable electrolytic tin plating at lead's side wall 14. In result, all side walls 14 of the packages 1 are tin plated.

In the fifth step (Fig. 2E), the conductive tape 20a is removed from the bottom of the packages 1. The conductive tape 20a is removed for example using UV or using heat, depending on the conductive tape material. For example, PVC-based conductive tape is removed by UV. UV or heat release is preferred, but these examples are not limiting - other types of conductive tape may be used.

As only metal areas which were not covered by conductive tape 20a were plated, after removal of conductive tape 20a, original metal surface which was covered by it is exposed without any plating 18. In other words, after removal of the conductive tape 20a only the side walls 14 of the packages 1 are tin plated. In effect, final product side walls 14 become wettable.

After removal of the conductive tape 20a, the final (second) cut 19 (step f) is performed to fully singulate the packages as in Fig. 1. This set of cuts 19 is orthogonal to the first set of cuts 16 and divides the structure into a grid.

This embodiment, in which conductive tape 20a fully covers terminal (contact pads 13) at bottom side, is applicable for lead frame pre-plated with wettable metal (for example: NiPdAu) package with tin plating only on the sides.

The following step order, described above, is applicable to dual flat no-lead (DFN) packages. In case of quad flat no-lead (QFN) packages, the second cut 19 is performed before plating (before step d), in order to allow all four side walls 14 (side flanks) of the package 1 to be exposed before plating, and thus plated. Thus, for QFN packages, the method steps are performed in the following order: providing an array of leadless packages 1 (a); applying the conductive tape 20a to the array of leadless packages 1 at the bottom side (b); performing the first set of cuts 16 to expose side walls 14 of the lead frame contact pad 13 (c); performing the second cut 19 expose all four side walls 14 of the package 1 (f); performing the plating process (d); removing the conductive tape 20a from the bottom of the packages 1 (e).

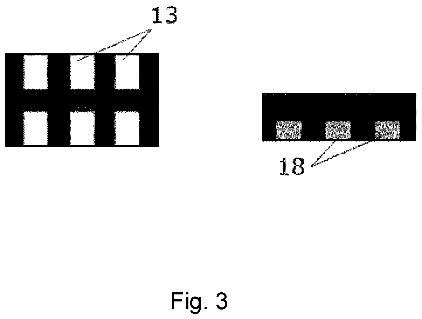

Fig. 3 depicts the package obtained according to the first embodiment in the top view, i.e. showing the bottom side of the package, as well as in the side view. The contact pads 13 of the bottom side are not tin plated.

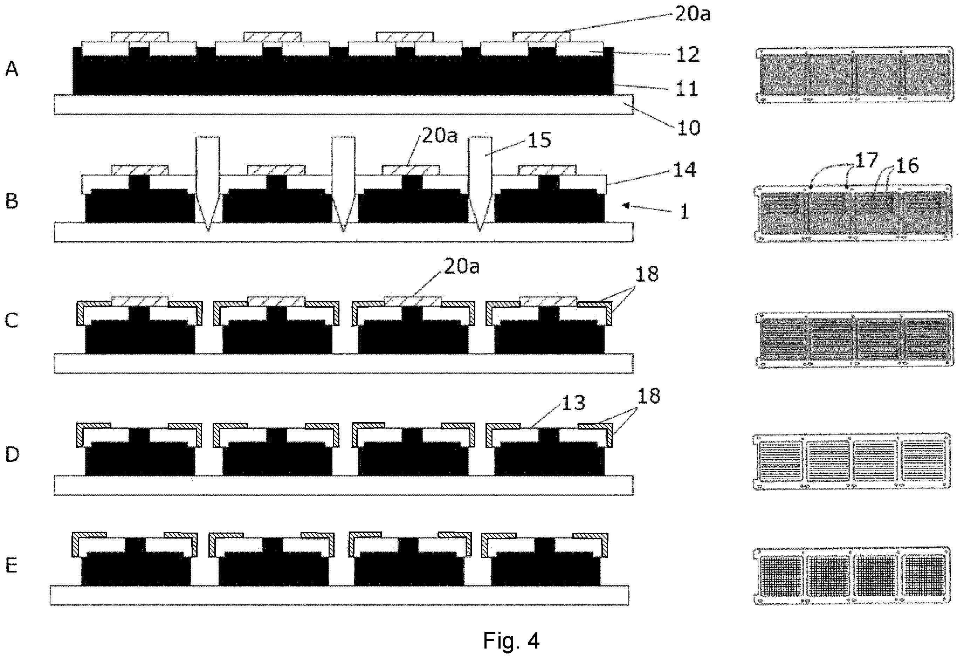

Figure 4 (partial Fig. 4A-4E) depicts a method according to the second embodiment, wherein the array of leadless packages placed on singulation tape 10 is shown in the cross-section, i.e. in the end view, and from above, i.e. from the lead frame level. In the second embodiment, the conductive substrate 20 is a conductive tape 20a. The conductive tape 20a may be for example a PVC-based conductive tape. Second embodiment allows for selective plating of the bottom side of the package 1. The lead frame is preferably pre-plated with wettable metal, for example NiPdAu. Providing packages with tin plating only on the sides and partially on the bottom side allows eliminate lead frame pre-plating cost.

In the first step (Fig. 4A), an array of leadless packages 1 placed on singulation tape 10 is provided, wherein the array comprises a lead frame 12, each having contact pads 13 at the underside and an encapsulation layer 11 in which the integrated circuits are encapsulated.

In the second step (Fig. 4B), the conductive tape 20a, for example adhesive conductive UV tape, is applied selectively to the array of leadless packages 1 at the I/O (bottom) side, to provide conductive path for the isolated I/O pins in molded package during electro-plating. The conductive tape 20a thus partially covers the bottom side of each package 1.

As shown in Fig. 4 (partial Fig. 4A-4E), the conductive tape 20a is placed in the middle of the package 1, connects them and covers the shorter end parts of the contact pads 13. However, as long as conductive tape 20a makes all terminals (contact pads) in the array electrically connected, it may be placed differently. For example, the end parts of the contact pads 13 may be exposed, whereby the middle parts of the contact pads 13 may be covered by conductive tape 20a.

In the third step (Fig. 4C), the first set of cuts 16 is performed to expose side walls 14 of the lead frame contact pad 13. The first set of cuts 16 extends through the lead frame 12 and the encapsulation layer 11, but it does not extend fully across the package 1 structures. Instead, the cuts terminate before the beginning and end of the rows such that the integrity of the array is maintained by edge portions at the ends of the rows. In effect, due to the presence of the conductive tape 20a, all contact pads 13 are electrically connected.

In the fourth step (Fig. 4D), the structure is suitable for handling by an automatic feeder for the plating process (traditional, known electro-plating and subsequent process). The base (bottom) areas of the contact pads 13 as well as the side walls 14 are thus plated as in the first embodiment. The conductive tape 20a acted as an electrical connecting media to enable electrolytic tin plating 18 at lead's side walls 14. In result, all side walls of the packages are tin plated. Since the conductive tape 20a covers the bottom side of the packages 1 selectively, the part of the bottom side lacking conductive tape 20a is also tin plated during the process.

In the fifth step (Fig. 4E), the conductive tape 20a is removed from the bottom of the packages 1. The conductive tape 20a is removed for example using UV or using heat, depending on the conductive tape material. For example, PVC-based conductive tape is removed by UV. UV or heat release is preferred, but these examples are not limiting - other types of conductive tape may be used.

As only metal areas which were not covered by conductive tape 20a were plated, after removal of conductive tape 20a, original metal surface which was covered by it is exposed without any plating. In the second embodiment, after removal of the conductive tape 20a, the side walls 14 of the packages 1 are tin plated, as well as parts of the bottom side of the packages 1.

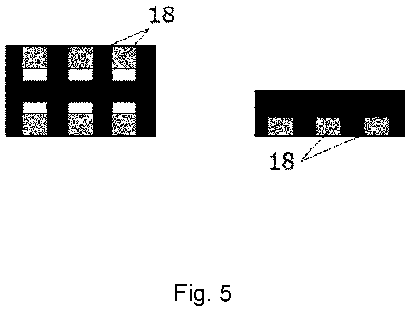

Fig. 5 shows the package obtained according to the second embodiment in the top view, i.e. showing the bottom side of the package 1, as well as in the side view. The contact pads 13 of the bottom side are selectively tin plated - the plating 18 is present only where the conductive tape 20a was not attached during plating process. The ends of the contact pads 13 have original lead frame surface finishing. As mentioned above, the arrangement of the tin plated and not plated areas of the bottom side depends on the arrangement of the conductive tape 20a. Selective taping thus enables unique plating pattern on final product.

After removal of the conductive tape 20a, the second cut 19 (step f) is performed to fully singulate the packages, as in Fig. 1. This second set of cuts 19 is orthogonal to the first set 16 and divides the structure into a grid.

The following step order, described above, is applicable to DFN packages. In case of QFN packages, the second cut 19 is performed before plating, in order to allow all four side walls 14 of the package 1 to be plated. For QFN packages the method steps are performed in the following order: providing an array of leadless packages 1 (a); applying the conductive tape 20a selectively to the array of leadless packages 1 at the bottom side (b); performing the first set of cuts 16 to expose side walls 14 of the lead frame contact pad 13 (c); performing the second cut 19 expose all four side walls 14 of the package 1 (f); performing the plating process (d); removing the conductive tape 20a from the bottom of the packages 1 (e).

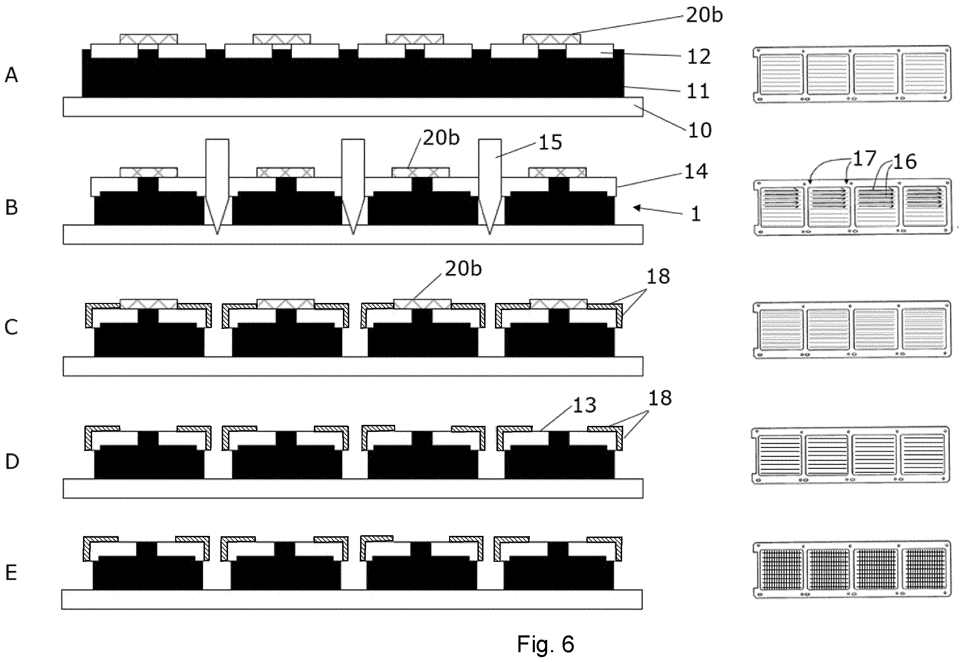

Figure 6 (partial Fig. 6A-6E) depicts a method according to the third embodiment, wherein the array of leadless packages 1 placed on singulation tape 10 is shown in the cross-section, i.e. in the end view, and from above, i.e. from the lead frame level. In the third embodiment, the conductive substrate 20 is a conductive glue 20b (the conductive glue 20b is shown, in the picture from above, as array of grey lines).

The lead frame is preferably pre-plated with wettable metal, for example NiPdAu.

In the first step (Fig. 6A), an array of leadless packages 1 placed on singulation tape 10 is provided, wherein the array comprises a lead frame 12, each having contact pads 13 at the underside and an encapsulation layer 11 in which the integrated circuits are encapsulated.

In the second step (Fig. 6B), the conductive glue 20b is applied selectively to the array of leadless packages 1 at the I/O (bottom) side, to provide conductive path for the isolated I/O pins in molded package during electro-plating.

The conductive glue 20b covers the bottom side of each package 1 partially. As shown in Fig. 6, the conductive glue 20b is placed in the middle of the package 1, and covers the shorter end parts of the contact pads 13. However, as long as conductive tape makes all terminals (contact pads 13) in the array electrically connected, it may be placed differently. For example, the end parts of the contact pads 13 may be exposed, whereby the middle parts of the contact pads 13 may be covered by conductive glue 20b. Due to the presence of the conductive glue 20b, all contact pads 13 are electrically connected, similarly as in the previous embodiments.

In the third step (Fig. 6C), the first set of cuts 16 is performed to expose side walls 14 of the lead frame contact pads 13, as in the first and second embodiments.

In the fourth step (Fig. 6D), the plating process is performed. The base areas of the contact pads 13 as well as the side walls 14 are thus plated as in the first and second embodiment. The conductive glue 20b acted as an electrical connecting media to enable electrolytic plating at lead's side walls 14. In result, all side walls 14 of the packages 1 have plating 18, for example tin plating. Since the conductive glue 20b covers the bottom side of the packages 1 selectively, the part of the bottom side lacking conductive glue 20b is also tin plated during the process.

In the fifth step (Fig. 6E), the conductive glue 20b is removed from the bottom of the packages 1. The conductive glue 20b is removed for example using UV or using heat, depending on the conductive glue material. For example, the conductive glue 20b is Ag filled PI based adhesive glue. UV or heat release is preferred, but these examples are not limiting - other types of conductive glue may be used.

As only metal areas which were not covered by conductive glue 20b were plated, after removal of conductive glue 20b, original metal surface which was covered by it is exposed without any plating. In the third embodiment, similarly as in the second embodiment, after removal of the conductive glue 20b, the side walls 14 of the packages 1 are tin plated, as well as parts of the bottom side of the packages.

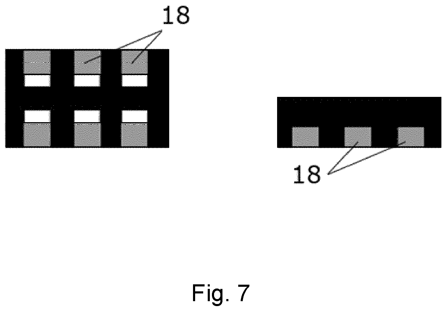

Similarly as for the second embodiment, Fig. 7 shows the package obtained according to the third embodiment in the top view, i.e. showing the bottom side of the package 1, as well as in the side view. The contact pads 13 of the bottom side are selectively tin plated - the plating 18 is present only where the conductive glue 20b was not attached during plating. The ends of the contact pads 13 have original lead frame surface finishing. As in the second embodiment, the arrangement of the tin plated and not plated areas of the bottom side depends on the arrangement of the conductive glue 20b. Selective gluing thus enables unique plating pattern on final product.

After removal of the conductive glue 20b, the second set of cuts 19 (step f) is performed to fully singulate the packages 1. This set of cuts 19 is orthogonal to the first set 16 and divides the structure into a grid.

The following step order, described above, is applicable to DFN packages. In case of QFN packages, the second cut is performed before plating, in order to allow all four side flanks of the package to be plated. Similarly as for the previous embodiments, for QFN packages the method steps are performed in the following order: providing an array of leadless packages 1 (a); applying the conductive glue 20b to the array of leadless packages 1 selectively at the bottom side (b); performing the first set of cuts 16 to expose side walls 14 of the lead frame contact pad 13 (c); performing the second cut 19 expose all four side walls 14 of the package 1 (f); performing the plating process (d); removing the conductive glue 20b from the bottom of the packages 1 (e).

In yet another embodiment, not shown in the Figures, the conductive glue 20b may fully cover the bottom side of the package 1 as in the first embodiment.

In each embodiment, preferably, each package 1 comprises six or more contact pads 13.

The present disclosure, by applying a "to-be-removed" conductive substrate 20 on the bottom side of the packages 1 (conductive tape 20a or conductive glue 20b), which becomes an electrical connecting media to enable electrolytic plating 18 at lead's side walls 14 (and at part of the bottom) and which may be removed after plating, allows to obtain a final product in which side walls 14 and optionally selected part of the bottom side become wettable. The full tin-plated side-wettable flanks guarantees that the complete side flank surface is wetted with solder during the reflow soldering process. An important advantage of this process is that the plating layer on the side flank is as thick as on the bottom pads - around 10µm. This guarantees a wettable surface even after long periods of storage. The height of the side-wettable flanks of a DFN package plated with this method depends on the lead frame thickness, but it meets the requirement of a minimum height of 100µm as raised by some automotive customers.

### LIST OF REFERENCE NUMERALS USED

- 1: package structure
- 10: singulation tape
- 11: encapsulation layer
- 12: lead frame
- 13: contact pad
- 14: side walls
- 15: sawing blade
- 16: first set of cuts
- 17: edge portions
- 18: plating
- 19: second set of cuts
- 20: conductive substrate
- 20a: conductive tape
- 20b: conductive glue

## Claims

1. A method of fabricating a semiconductor integrated circuits package with solder wettable plating, comprising the following steps:
(a) providing an array of leadless packages (1) placed on singulation tape (10), wherein the array comprises a lead frame (12), each having contact pads (13) at the underside and an encapsulation layer (11) in which the integrated circuits are encapsulated;
(b) adjoining a conductive substrate (20a, 20b) to the array of leadless packages (1) at the bottom side, thereby electrically connecting all contact pads (13) of the array;
(c) performing a first set of parallel cuts (16), extending fully through the lead frame (12) and encapsulation layer (12), and defining rows of the array, thereby exposing the side walls (14) of the lead frames (12);
(d) performing the process of electro-plating of the lead frame (12), thereby obtaining plating (18) on the areas not covered by the conductive substrate (20a, 20b);
(e) removing the conductive substrate (20a, 20b) from the bottom of the packages (1);
(f) performing a second series of parallel cuts (19), angled with respect to the first series of parallel cuts (16), the cuts extending fully through the lead frame (12) and the encapsulation layer (11), and separating the array into columns thereby singulating the packages (1) between the edge portions (17),
whereby step (f) is performed after step (e) or between steps (c) and (d).

2. A method of fabricating a semiconductor integrated circuits package with solder wettable plating according to claim 1, wherein the conductive substrate (20a, 20b) is a conductive tape (20a).

3. A method of fabricating a semiconductor integrated circuits package with solder wettable plating according to claim 2, wherein the conductive tape (20a) fully covers the bottom side of each package (1).

4. A method of fabricating a semiconductor integrated circuits package with solder wettable plating according to claim 2, wherein the conductive tape (20a) partially covers the bottom side of each package (1).

5. A method of fabricating a semiconductor integrated circuits package with solder wettable plating according to claim 1, wherein the conductive substrate (20a, 20b) is a conductive glue (20b).

6. A method of fabricating a semiconductor integrated circuits package with solder wettable plating according to claim 5, wherein the conductive glue (20b) fully covers the bottom side of each package (1).

7. A method of fabricating a semiconductor integrated circuits package with solder wettable plating according to claim 5, wherein the conductive glue (20b) partially covers the bottom side of each package (1).

8. A method of fabricating a semiconductor integrated circuits package with solder wettable plating according to any one of the preceding claims, wherein the plating (18) is tin plating.

9. A method of fabricating a semiconductor integrated circuits package with solder wettable plating according to any one of the preceding claims, wherein each package (1) comprises six contact pads (13).

10. A method of fabricating a semiconductor integrated circuits package with solder wettable plating according to any one of the preceding claims, wherein the conductive substrate (20a, 20b) is UV-releasable and is removed using UV.

11. A method of fabricating a semiconductor integrated circuits package with solder wettable plating according to any one of claims 1 to 9, wherein the conductive substrate (20a, 20b) is heat-releasable and is removed using heat.
